# EUROPEAN PATENT SPECIFICATION

(11) **EP 4 369 395 B1**
(45) Date of publication and mention of the grant of the patent: **27.08.2025**
(21) Application number: 22206772.0
(22) Date of filing: 10.11.2022
(51) Int. Cl.: H01L 23/498, H01L 23/50

(54) **PACKAGE FOR A LATERAL POWER TRANSISTOR**
VERPACKUNG FÜR EINEN LATERALEN LEISTUNGSTRANSISTOR
BOÎTIER POUR TRANSISTOR DE PUISSANCE LATÉRAL

(43) Date of publication of application: 15.05.2024
(73) Proprietor: Infineon Technologies Austria AG, 9500 Villach (AT)
(72) Inventor: CHUA, Kok Yau, 75050 Melaka (MY); JONES, Edward Andrew, 9500 Villach (AT); MOSTOFIZADEH, Milad, 81673 München (DE); NG, Chee Yang, 84000 Muar (MY); SCHIESS, Klaus, 78476 Allensbach (DE); TEE, Guan Choon Matthew Nelson, 75350 Malacca (MY)
(74) Representative: Lambsdorff & Lange Patentanwälte Partnerschaft mbB

(56) References cited:
- US-A1- 2002 076 851

## Description

### Technical Field

This disclosure relates generally to the technique of semiconductor packaging, and in particular to a transistor package for a lateral transistor device.

### Background

Transistor packages are widely used as electronic switches in a variety of electronic circuits. Higher efficiency, increased power density, lower switching losses, faster switching times, lower device parasitics and lower cost are among the key goals for next generation transistor package design.

The transistor switching performance is limited by parasitic elements from the transistor package and the board. In particular, the parasitic common source inductance causes switching losses.

Conventional approaches to reduce device parasitics for fast switching and to improve thermal behavior are to use leadless packages and/or to use clips for connecting the load electrodes of a semiconductor transistor chip to the respective terminals of the transistor package.

Existing package solutions use an additional pin for a source Kelvin connection as a reference potential for the gate driving voltage. However, the presence of a source Kelvin pin and source Kelvin connection degrades the package inductance and package resistance.

Document US 2002/076851 A1 discloses the preamble of independent claim 1.

### Summary

According to an aspect of the disclosure, a transistor package for a power transistor chip includes the power transistor chip having a first side and a second side opposite the first side. The first side comprises a source electrode metallization, a drain electrode metallization and a gate electrode metallization. The package further includes a multi-layer laminate substrate to which the power transistor chip is connected. The multi-layer laminate substrate comprises a first structured metal layer facing the first side of the power transistor chip and being electrically connected to the source electrode metallization, the drain electrode metallization and the gate electrode metallization, a second structured metal layer comprising a source package terminal pad, a source sense package terminal pad, a drain package terminal pad and a gate package terminal pad, at least one insulating layer disposed between the first structured metal layer and the second structured metal layer, and a plurality of vias running through the insulating layer and connecting segments of the first structured metal layer to the terminal pads of the second structured metal layer. The first structured metal layer, the second structured metal layer and the plurality of vias are designed such that a gate-source current path between the power transistor chip and the source sense package terminal pad is provided only on one of the first and second structured metal layers while a drain-source current path between the source electrode metallization of the power transistor chip and the source package terminal pad is at least on the other structured metal layer of the multi-layer laminate substrate.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a perspective top view of an example of a transistor package illustrated in a semi-transparent representation.
Figure 2A is a bottom view a transistor package in accordance with a first variant.
Figure 2B is a bottom view of a transistor package in accordance with a second variant.
Figure 3 is a plan view of a portion of an exemplary electrode metallization layout of a power transistor chip.
Figure 4A is a plan view of a first structured metal layer facing the power transistor chip according to a first example of a transistor package.
Figure 4B is a plan view of a second structured metal layer the transistor package of Figure 4A.
Figure 5A is a schematic cross-sectional view of the transistor package of Figures 4A, 4B along line A-A' of Figures 4A and 4B.
Figure 5B is a schematic cross-sectional view of the transistor package of Figures 4A, 4B along line B-B' of Figures 4A and 4B.
Figure 6A is a plan view of a first structured metal layer facing the power transistor chip according to a second example of a transistor package.
Figure 6B is a plan view of a second structured metal layer the transistor package of Figure 6A.
Figure 7A is a schematic cross-sectional view of the transistor package of Figures 6A, 6B along line A-A' of Figures 6A and 6B.
Figure 7B is a schematic cross-sectional view of the transistor package of Figures 6A, 6B along line B-B' of Figures 6A and 6B.
Figure 8A is a plan view of a first structured metal layer facing the power transistor chip according to a third example of a transistor package.
Figure 8B is a plan view of a second structured metal layer the transistor package of Figure 8A.
Figure 9A is a schematic cross-sectional view of the transistor package of Figures 8A, 8B along line A-A' of Figures 8A and 8B.
Figure 9B is a schematic cross-sectional view of the transistor package of Figures 8A, 8B along line B-B' of Figures 8A and 8B.
Figure 10 is a perspective top view of a detail of Figure 1.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

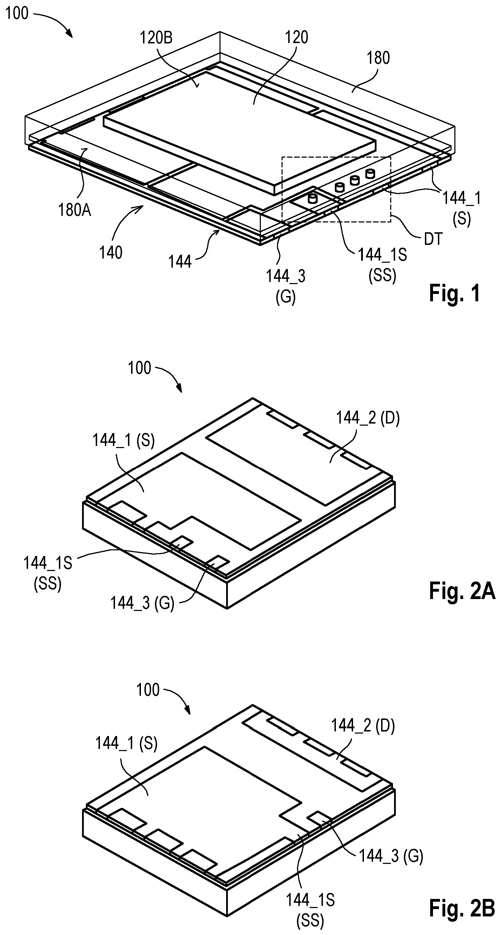

Referring to Figure 1, a transistor package 100 includes a power transistor chip 120. The power transistor chip 120 has a first side (not visible in Figure 1) and a second side 120B opposite the first side.

The semiconductor transistor chip 120 is a lateral device, i.e. the first side comprises a source electrode metallization, a drain electrode metallization and a gate electrode metallization. The metallizations are all disposed on the same (first) side of the semiconductor transistor chip 120. In other words, the lateral semiconductor transistor chip 120 is implemented in the transistor package 100 in a flip-chip orientation.

The power transistor chip 120 may be, e.g., capable of switching high currents and/or medium or high voltages (e.g. more than 50 V or 100 V or 200 V or 300 V blocking voltage). In particular, exemplary transistor packages as disclosed herein may operate in the medium voltage (MV) range, in which the blocking voltage is equal to or greater than or less than 200 V or 150 V or 100 V or 50 V.

The power transistor chip 120 may be of different types. Examples described herein are, in particular, directed, e.g., to HEMT (high electron mobility transistor) devices. More specifically, the semiconductor transistor chip 120 referred to herein may, e.g., be a III-V compound semiconductor chip having, e.g., a high band gap. The power transistor chip 120 may, e.g., be a GaN chip. In this case, the GaN chip 120 may be a lateral GaN-on-substrate device such as a GaN-on-Si device or a GaN-on-SiC device or a GaN-on-sapphire device, for example.

The transistor package 100 may include a multi-layer laminate substrate (will be described further below) to which the power transistor chip 120 is connected (e.g. mounted).

The source, drain and gate electrode metallizations of the power transistor chip 120 are connected via a first structured metal layer (will be described further below) of the multi-layer laminate substrate to a second structured metal layer 144 of multi-layer laminate substrate. The second structured metal layer 144 may be exposed at the bottom of the transistor package 100 and includes a source package terminal pad 144_1 also denoted by S, a drain package terminal pad 144_2 also denoted by D, and a gate package terminal pad 144_3 also denoted by G, see, e.g., the exemplary footprints of transistor packages 100 shown in Figures 2A and 2B.

As illustrated in the semi-transparent representation of Figure 1, the power transistor chip 120 may be embedded in a mold compound 180. The mold compound 180 may cover the multi-layer laminate substrate to which the power transistor chip 120 is connected. A periphery of the mold compound 180 is denoted by reference sign 180A.

The second structured metal layer 144, providing for the package terminals, further includes a source sense package terminal pad 144_1S also denoted by SS. The source sense package terminal pad 144_1S, which is also referred to as Kelvin sense terminal pad in the art, may, e.g., be implemented either as an separate (insular) package terminal pad (Figure 2A) or as a terminal pad which is continuous with the source package terminal 144_1 (Figure 2B). As will be described in the following, both variants (Figure 2A: separate source sense package terminal pad 144_1S; or Figure 2B: integral source sense package terminal pad 144_1S) can be designed to provide low device parasitics and therefore fast switching of transistor packages 100 described herein.

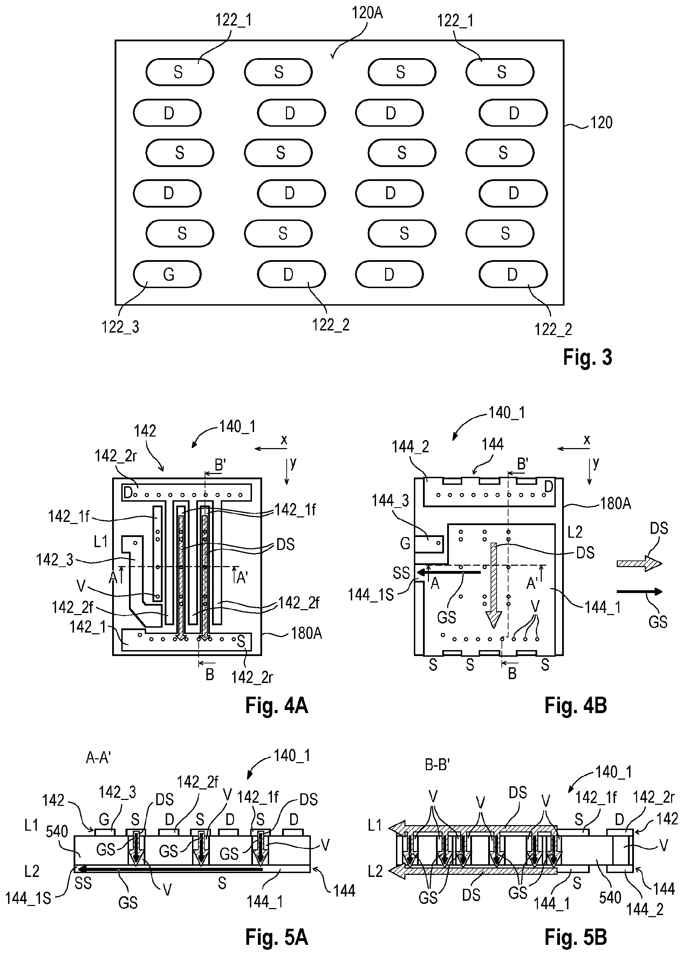

Figure 3 is a partial plan view illustration a portion of an exemplary layout of source, drain and gate electrode metallizations at the first side 120A of the power transistor 120. The layout is shown from top, i.e. as it would be seen through the power transistor chip 120.

A source electrode metallization 122_1 may include a plurality of source contact pads (S), and a drain electrode metallization 122_2 may include a plurality of drain contact pads (D). Further, a gate electrode metallization 122_3 is provided.

The plurality of source contact pads (S) may, e.g., be arranged in a number of (horizontal) rows parallel to the longitudinal side of the power transistor chip 120. Likewise, the plurality of drain contact pads (D) may be arranged in a number of (horizontal) rows parallel with the rows of the source contact pads (S). In the example shown in Figure 3, the rows of source contact pads (S) and the rows of drain contact pads (D) are interleaved (or alternating). Further, the source contact pads (S) and the drain contact pads D) are offset from each other in the longitudinal (horizontal) direction. The gate electrode metallization 122_3 may be arranged at a corner of the power transistor chip 120 and may, e.g., be formed by as single gate contact pad (G).

The contact pad layout at the first side 120A of the power transistor chip 120 may, e.g., not include a source sense pad. That is, the multi-layer laminate substrate 140 (but, e.g., not an integrated circuitry of the power transistor chip 120) may provide the internal package interconnects between the source contact pads (S) of the power transistor chip 120 and the source package terminal pad 144_1 and the source sense package terminal pad 144_1S, respectively, of the transistor package 100.

The (exemplary) layout of the source, drain and gate metallization 122_1, 122_2, 122_3 of the power transistor chip 120 apparently needs to be re-routed by a package-internal interconnect in order to provide for a layout of package terminal pads 144_1, 144_2, 144_3 and 144_1S as, e.g., shown in Figures 1A or 2A. Re-routing is carried out by the multi-layer laminate substrate 140.

Figures 4A-4B and 5A-5B illustrate a first example of a multi-layer laminate substrate 140, referred to as multi-layer laminate substrate 140_1 in the following. The multi-layer laminate substrate 140_1 includes a first structured metal layer 142, also referred to as L1 metal, and the second structured metal layer 144, also referred to as L2 metal.

The first structured metal layer 142 faces the first side 120A of the power transistor chip 120. The first structured metal layer 142 may, e.g., include a multi-finger source segment 142_1, wherein fingers 142_1f of the multi-finger source segment 142_1 are connected to the source contact pads (S) of the source electrode metallization 122_1 of the power transistor chip 120. Further, the first structured metal layer 142 may, e.g., include a multi-finger drain segment 142_2 having fingers 142_2f connected to the drain contact pads (D) of the drain electroe metallization 122_2 of the power transistor chip 120. The fingers 142_1f and the fingers 142_2f may, e.g., be interdigitated so as to allow to separately connect to the source contact pads (S) and the drain contact pads (S) at the first side 120A of the power transistor chip 120 (see, e.g., Figure 3).

Further, the first structured metal layer 142 may include a gate segment 142_3 which connects to the gate contact pad 122_3 of the power transistor chip 120.

It is to be noted that a variety of different layouts of the source (S), drain (D) and gate (G) contact pads of the metallizations 122_1, 122_2, 122_3 at the first side 120A of the power transistor chip 120 is possible. Correspondingly, the layout of the first structured metal layer 142, which is adapted to the layout of the source (S), drain (D) and gate (G) contact pads of the metallizations 122_1, 122_2, 122_3 of the power transistor chip 120, may be designed in a variety of different patterns.

In many examples the layout of the first structured metal layer 142 is chosen to route the drain and source currents to different (e.g. opposite) sides of the transistor package 100. In the specific example shown in Figures 4A-5B, this separation of drain and source current is carried out by the fingers 142_1f, 142_2f of the multi-finger source and drain segments 142_1, 142_2, respectively. To this end, the fingers 142_1f or at least a part thereof (as in the example shown) may be connected to a rail portion 142_1r of the multi-finger source segment 142_1. Likewise, the fingers 142_2f of the multi-finger drain segment 142_2 may be connected to a rail portion 142_2r of the multi-finger drain segment 142_2, wherein the rail portions 142_1r and 142_2r may be located at opposite sides of the transistor package 100.

The rail portions 142_1r and 142_2r may, e.g., be parallel with each other and may, e.g., extend in X-direction. The fingers 142_1f, 142_2f may, e.g., be parallel with each other and may, e.g., extend in Y-direction, which is perpendicular to the X-direction.

Figure 4B is a plan view of the second structured metal layer 144. The second structured metal layer 144 includes the source (S) package terminal pad 144_1, the drain (D) package terminal pad 144_2 and the gate (G) package terminal pad 144_3. Further, a source sense (SS) package terminal pad 144_1S is provided.

In a first example, the source sense (SS) package terminal pad 144_1S and the source (S) package terminal pad 144_1 are formed by a continuous metal segment of the second structured metal layer 144.

At least one insulating layer 540 is disposed between the first structured metal layer 142 (L1) and the second structured metal layer 144 (L2). A plurality of vias V is running through the insulating layer 540. The vias V connect segments of the first structured metal layer (L1) 142 to the terminal pads 144_1, 144_2, 144_3, 144_1S of the second structured metal layer 144 (L2). Vias V are indicated in Figures 4A-4B by circles.

In Figures 4A to 5B the drain-source current path DS and the gate-source current path GS are indicated by arrows. The (large) drain-source current is flowing along the drain-source current path DS, while the (small) gate-source current is flowing along the gate-source current path GS.

As apparent from Figures 4A to 5B, the drain-source current path DS between the source electrode metallization 122_1 of the power transistor chip 120 and the source (S) package terminal pad 144_1 flows on (at least) two structured layers of the multi-layer laminate substrate 140_1, namely on the first structured metal layer 142 (L1) and on the second structured metal layer 144 (L2). On the other hand, the gate-source current path GS between the source electrode metallization 122_1 of the power transistor chip 120 and the source sense (SS) package terminal pad 144_1S is provided only on one of the first and second structured metal layers 142 (L1), 144 (L2), namely on the second structured metal layer 144 (L2).

For example, the drain-source current path DS on the first and second structured metal layers 142, 144 is in the lateral Y-direction and the gate-source current path GS on the second structured metal layer 144 (L2) only is in the lateral X-direction, wherein the lateral Y-direction and the lateral X-direction are different from each other and, e.g., perpendicular to each other.

In other words, while the drain-source current flows on two layers L1, L2 of the transistor package 100 in the Y-direction, the gate-source current only flows on one of those two layers (here: layer L2) in the X-direction, thereby partly decoupling the two current paths DS and GS.

Further, the gate segment 142_3 which connects the gate contact metallization 122_3 of the power transistor chip 120 through vias V to the gate (G) package terminal pad 144_3 of the transistor package 100 may be designed, e.g., to allow the gate (G) package terminal pad 144_3 to be located at a side of the transistor package 100 oriented in Y direction (this is also referred to as a "center gate layout"). That is, the source package terminal pad 144_1 may be arranged along a first side of the transistor package 100, the drain package terminal pad 144_2 may be arranged along a second side opposite the first side of the transistor package 100 and the gate package terminal pad 144_3 may be arranged at a third side of the transistor package in a region spaced apart from a corner of the first or second side of the transistor package 100.

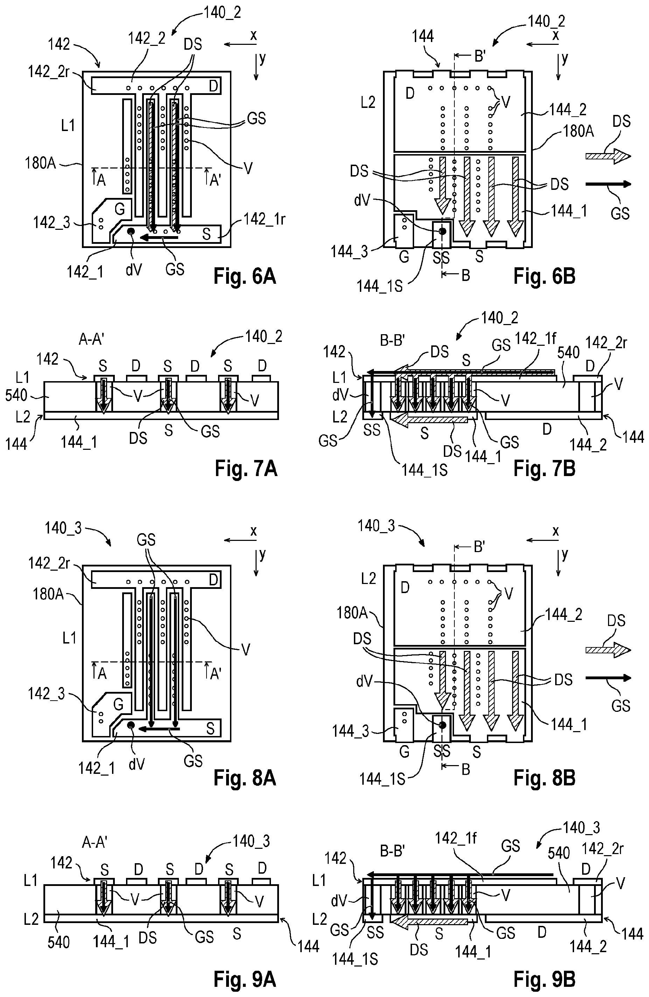

Figures 6A to 7B illustrate a second example of a multi-layer laminate substrate 140, referred to as multi-layer laminate substrate 140_2 in the following. The multi-layer laminate substrate 140_2 may be used in a transistor package in accordance with the first variant (see Figure 2A). In other words, the source sense (SS) package terminal pad 144_1S and the source (S) package terminal pad 144_1 are formed by separate metal segments of the second structured metal layer 144 (L2).

As illustrated in Figures 6A to 7B, the drain-source current path DS is on the first and second structured metal layers 142 (L1) and 144 (L2), whereas the gate-source current path GS is only on the first structured metal layer 142 (L1). The drain-source current path DS on the first and second structured metal layers 142 (L1) and 144 (L2) is, e.g., in the lateral Y-direction. The gate-source current path GS on the first structured metal layer 142 is also, at least partially, in the Y-direction. Further, gate-source current path GS may be (partially) in the X-direction along the rail 142_1r to a dedicated via dV through which the separate source sense (SS) package terminal pad 144_1S is connected to the first metal layer 142 (L1). No drain-source current is flowing through the dedicated via dV.

In other words, in the second example of a transistor package 100 the drain-source current flows on two metal layers L1, L2 of the multi-layer laminate substrate 140 in the Y-direction, while the gate-source current only flows on one (namely L1) of those two metal layers L1, L2 in (at least partially) the Y-direction and utilizes the dedicated via dV to connect to the insular source sense (SS) package terminal pad 144_1S at the package footprint.

Further, the gate segment 142_3 which connects the gate contact metallization 122_3 of the power transistor chip 120 through vias V to the gate (G) package terminal pad 144_3 of the transistor package 100 may be, e.g., designed to allow the gate (G) package terminal pad 144_3 to be located at a corner of the transistor package 100 (this is also referred to as a "corner gate layout"). For example, the source package terminal pad 144_1 may be arranged along a first side of the transistor package 100, the drain package terminal pad 144_2 may be arranged along a second side opposite the first side of the transistor package 100 and the gate package terminal pad 144_3 may be arranged at a corner of the first side of the transistor package 100.

Figures 8A to 9B illustrate a third example of a transistor package 100 which includes a third example of a multi-layer laminate substrate 143, referred to as multi-layer laminate substrate 140_3 in the following. Similar to the multi-layer laminate substrate 140_2, the semiconductor package uses a dedicated via dV connecting to an insular source sense (SS) package terminal pad 144_1S. Differently stated, the source sense (SS) package terminal pad 144_1S and the source (S) package terminal pad 144_1 are formed by separate metal segments of the second structured metal layer 144. However, the third example of a transistor package (Figures 8A to 9B) distinguishes from the second example (Figures 6A to 7B) in that the drain-source current path DS is only on the second structured metal layer 144 (L2) and the gate-source current path GS is only on the first structured metal layer 142 (L1). The multi-layer laminate substrate 140_3 provides fully decoupled drain-source and gate-source current paths DS and GS.

For example, the drain-source current path DS on the second structured metal layer 144 (L2) is in the Y-direction, and the gate-source current path GS on the first structured metal layer 142 (L1) is also, at least partially, in the Y-direction.

Further, the gate segment 142_3 which connects the gate contact metallization 122_3 of the power transistor chip 120 through vias V to the gate (G) package terminal pad 144_3 of the transistor package 100 may, e.g., designed to allow the gate (G) package terminal pad 144_3 to be located at a corner of the transistor package 100 ("corner gate layout"). Reference is made to the above description of a "corner gate layout" to avoid reiteration.

The various implementations according the first, second and third examples disclosed above are summarized in Table 1.

**Table 1**

| | ex. 1 (140_1) | ex. 2 (140_2) | ex. 3 (140_3) |
|---|---|---|---|
| DS current through | L1 + L2 | L1 + L2 | L2 |
| GS current through | L2 | L1 | L1 |
| Dedicated via dV and insular SS pad | No | Yes | Yes |

While examples 1 and 2 (multi-layer laminate substrates 140_1 and 140_2, respectively) provide for partial decoupling of the drain-source current and the gate-source current, the example 3 fully decouples the drain-source current path DS and the gate-source current pat GS. In all examples 1 to 3 the source sense (SS) terminal pad 144_1S ("Kelvin source pad") for the gate-source current is connected to the power transistor chip 120 on only one of the metal layers L1, L2, and the at least one other metal layer L2 or L1, respectively, is used to provide an alternate path for the drain-source current between the source electrode metallization 122_1 of the power transistor chip 120 and the (power) source package terminal pad 144_1 of the transistor package 100. Further, it is to be noted that a dedicated via dV can be used either in a partially decoupled implementation (e.g. ex. 2, 140_2) or a fully decoupled implementation (e.g. ex. 3, 140_3). Moreover, center gate or corner gate layouts may be used in any of the implementations as disclosed.

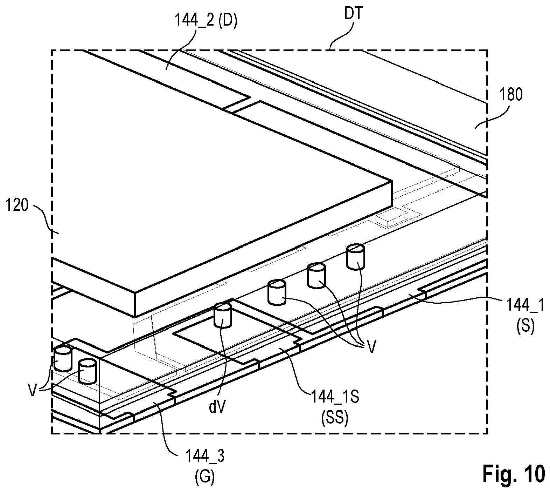

Figure 10 is a perspective top view of detail DT of Figure 1. The semi-transparent representation shows the dedicated via dV connecting to the insular source sense (SS) package terminal pad 144_1S (SS). Reference is made to Figures 2A and Figures 6A to 9B in which implementations in line with such footprint layout are presented, for example.

Due to the face-down orientation of the semiconductor transistor chip 120, the transistor packages 100 disclosed herein allow to achieve low parasitics for fast switching and high thermal connectivity. In all examples, the array of vias V provides a vertical connection structure of low parasitic inductance in the multi-layer laminate structure 140 to connect the source electrode metallization 122_1 of the power transistor chip 120 to the source package terminal pad 144_1 of the transistor package 100. In addition, the partially or fully decoupling of the (large) load DS and the (small) source sense GS currents allows to offer a source Kelvin IO pin (i.e. the source sense package terminal pad 144_1S) with minimum parasitic inductance. In particular, a dedicated via dV connecting the source electrode metallization 122_1 of the power transistor chip 120 to the source sense (SS) package terminal pad 144_1S of the transistor package 100 may improve the switching frequency.

Further, for example given a GaN semiconductor transistor chip 120 is used, the face-down orientation of the GaN transistor chip 120 in combination with the multi-layer laminate substrate 140, which can be used as a routable base of the transistor package 100, allows to align the transistor package footprint with the footprints of common MOSFET (Metal Oxide Semiconductor Field Effect Transistor) packages which, however, cannot fulfill the fast switching requirements of the transistor package 100 described herein.

The multi-layer laminate substrate 140 may be represented by a variety of different structures and formed by a variety of different methods of manufacturing. For example, the multi-layer laminate substrate 140 may comprise or be a separate PCB (Printed Circuit Board) on which the power transistor chip 120 chip is mounted. In other examples, the multi-layer laminate substrate may be generated at wafer level by, e.g., embedded wafer level packaging techniques, also known as eWLP in the art. In eWLP, the transistor packages 100 are separated from an "artificial wafer" in which an array of power transistor chips 120 is embedded in a continuous mold compound wafer structure.

The invention is defined by the appended claims.

## Claims

1. A transistor package for a power transistor chip, the transistor package comprising:
the power transistor chip (120) having a first side (120A) and a second side opposite the first side (120A), the first side (120A) comprising a source electrode metallization (122_1), a drain electrode metallization (122_2) and a gate electrode metallization (122_3); and
a multi-layer laminate substrate (140) to which the power transistor chip (120) is connected, the multi-layer laminate substrate (140) comprising
a first structured metal layer (142) facing the first side (120A) of the power transistor chip (120) and being electrically connected to the source electrode metallization (122_1), the drain electrode metallization (122_2) and the gate electrode metallization (122_3);
a second structured metal layer (144) comprising a source package terminal pad (144_1), a source sense package terminal pad (144_1S), a drain package terminal pad (144_2) and a gate package terminal pad (144_3);
at least one insulating layer (550) disposed between the first structured metal layer (142) and the second structured metal layer (144); and
a plurality of vias (V) running through the insulating layer (550) and connecting segments of the first structured metal layer (142) to the terminal pads of the second structured metal layer (144); **characterized in that**
the first structured metal layer (142), the second structured metal layer (144) and the plurality of vias (V) are designed such that a gate-source current path (GS) between the power transistor chip (120) and the source sense package terminal pad (144_1S) is provided only on one of the first and second structured metal layers (142, 144) while a drain-source current path (DS) between the source electrode metallization (122_1) of the power transistor chip (120) and the source package terminal pad (144_1) is at least on the other structured metal layer of the multi-layer laminate substrate (140).

2. The transistor package of claim 1, wherein the source sense package terminal pad (144_1S) and the source package terminal pad (144_1) are formed by a continuous metal segment of the second structured metal layer.

3. The transistor package of claim 1 or 2, wherein the drain-source current path (DS) is on the first and second structured metal layers (142, 144), and the gate-source current path (GS) is only on the second structured metal layer (144).

4. The transistor package of claim 3, wherein the drain-source current path (DS) on the first and second structured metal layers (142, 144) is in a lateral direction Y and the gate-source current path (GS) on the second structured metal layer (144) is in a lateral direction X, wherein the lateral direction Y and the lateral direction X are different from each other.

5. The transistor package of claim 1, wherein the source sense package terminal pad (144_1S) and the source package terminal pad (144_1) are formed by separate metal segments of the second structured metal layer (144).

6. The transistor package of claim 5, wherein the drain-source current path (DS) is on the first and second structured metal layers (142, 144), and the gate-source current path (GS) is only on the first structured metal layer (142).

7. The transistor package of claim 6, wherein the drain-source current path (DS) on the first and second structured metal layers (142, 144) is in a lateral direction Y and the gate-source current path (GS) on the first structured metal layer (142) is also at least partially in the lateral direction Y.

8. The transistor package of claim 5, wherein the drain-source current path (DS) is only on the second structured metal layer (144), and the gate-source current path (GS) is only on the first structured metal layer (142).

9. The transistor package of claim 8, wherein the drain-source current path (DS) on the second structured metal layer (144) is in a lateral direction Y and the gate-source current path (GS) on the first structured metal layer (142) is also at least partially in the lateral direction Y.

10. The transistor package of any one of claims 5 to 9, wherein the separate source sense package terminal pad (144_1S) is connected to the first structured metal layer (142) by a dedicated via (dV) through which no drain-source current is flowing.

11. The transistor package of any preceding claim, wherein the first structured metal layer (142) comprises a multi-finger drain segment (142_2) connected to the drain electrode metallization (122_2) and a multi-finger source segment (142_1) connected to the source electrode metallization (122_1), wherein the multi-finger drain segment (142_2) and the multi-finger source segment (142_1) are interdigitated.

12. The transistor package of any preceding claim, wherein the source package terminal pad (144_1) is arranged along a first side of the transistor package, the drain package terminal pad (144_2) is arranged along a second side opposite the first side of the transistor package and the gate package terminal pad (144_3) is arranged at a corner of the first side of the transistor package.

13. The transistor package of any of claims 1 to 11, wherein the source package terminal pad (144_1) is arranged along a first side of the transistor package, the drain package terminal pad (144_2) is arranged along a second side opposite the first side of the transistor package and the gate package terminal pad (144_3) is arranged at a third side of the transistor package in a region spaced apart from a corner of the first or second side of the transistor package.

14. The transistor package of any preceding claim, further comprising:
a mold compound embedding the power transistor chip (120) and covering the multi-layer laminate substrate (140) outside the area where the power transistor chip (120) is placed.

15. The transistor package of any preceding claim, wherein the power transistor chip (120) is a HEMT transistor chip and/or a GaN transistor chip.

16. The transistor package of any preceding claim, wherein the power transistor chip (120) is configured to switch drain-source voltages equal to or greater than 50 V or 100 V or 150 V or 200 V.

## Patentansprüche

1. Transistorgehäuse für einen Leistungstransistorchip, wobei das Transistorgehäuse Folgendes umfasst:
den Leistungstransistorchip (120) mit einer ersten Seite (120A) und einer zweiten Seite gegenüber der ersten Seite (120A), wobei die erste Seite (120A) eine Sourceelektrodenmetallisierung (122_1), eine Drainelektrodenmetallisierung (122_2) und eine Gateelektrodenmetallisierung (122_3) umfasst; und
ein Mehrschichtlaminatsubstrat (140), mit dem der Leistungstransistorchip (120) verbunden ist, wobei das Mehrschichtlaminatsubstrat (140) Folgendes umfasst:
eine erste strukturierte Metallschicht (142), die der ersten Seite (120A) des Leistungstransistorchips (120) zugewandt ist und elektrisch mit der Sourceelektrodenmetallisierung (122_1), der Drainelektrodenmetallisierung (122_2) und der Gateelektrodenmetallisierung (122_3) verbunden ist;
eine zweite strukturierte Metallschicht (144), die ein Source-Gehäuseanschlusspad (144_1), ein Source-Sense-Gehäuseanschlusspad (144_1S), ein Drain-Gehäuseanschlusspad (144_2) und ein Gate-Gehäuseanschlusspad (144_3) umfasst;
mindestens eine Isolationsschicht (550), die zwischen der ersten strukturierten Metallschicht (142) und der zweiten strukturierten Metallschicht (144) angeordnet ist; und
eine Mehrzahl von Vias (V), die durch die Isolationsschicht (550) verläuft und Segmente der ersten strukturierten Metallschicht (142) mit den Anschlusspads der zweiten strukturierten Metallschicht (144) verbindet; **dadurch gekennzeichnet, dass**
die erste strukturierte Metallschicht (142), die zweite strukturierte Metallschicht (144) und die Mehrzahl von Vias (V) so ausgelegt sind, dass ein Gate-Source-Strompfad (GS) zwischen dem Leistungstransistorchip (120) und dem Source-Sense-Gehäuseanschlusspad (144_1S) nur auf einer der ersten und der zweiten strukturierten Metallschicht (142, 144) vorgesehen ist, während ein Drain-Source-Strompfad (DS) zwischen der Sourceelektrodenmetallisierung (122_1) des Leistungstransistorchips (120) und dem Source-Gehäuseanschlusspad (144_1) mindestens auf der anderen strukturierten Metallschicht des Mehrschichtlaminatsubstrats (140) ist.

2. Transistorgehäuse nach Anspruch 1, wobei das Source-Sense-Gehäuseanschlusspad (144_1S) und das Source-Gehäuseanschlusspad (144_1) durch ein kontinuierliches Metallsegment der zweiten strukturierten Metallschicht ausgebildet sind.

3. Transistorgehäuse nach Anspruch 1 oder 2, wobei der Drain-Source-Strompfad (DS) auf der ersten und der zweiten strukturierten Metallschicht (142, 144) ist und der Gate-Source-Strompfad (GS) nur auf der zweiten strukturierten Metallschicht (144) ist.

4. Transistorgehäuse nach Anspruch 3, wobei der Drain-Source-Strompfad (DS) auf der ersten und der zweiten strukturierten Metallschicht (142, 144) in einer lateralen Richtung Y ist und der Gate-Source-Strompfad (GS) auf der zweiten strukturierten Metallschicht (144) in einer lateralen Richtung X ist, wobei sich die laterale Richtung Y und die laterale Richtung X voneinander unterscheiden.

5. Transistorgehäuse nach Anspruch 1, wobei das Source-Sense-Gehäuseanschlusspad (144_1S) und das Source-Gehäuseanschlusspad (144_1) durch separate Metallsegmente der zweiten strukturierten Metallschicht (144) ausgebildet sind.

6. Transistorgehäuse nach Anspruch 5, wobei der Drain-Source-Strompfad (DS) auf der ersten und der zweiten strukturierten Metallschicht (142, 144) ist und der Gate-Source-Strompfad (GS) nur auf der ersten strukturierten Metallschicht (142) ist.

7. Transistorgehäuse nach Anspruch 6, wobei der Drain-Source-Strompfad (DS) auf der ersten und der zweiten strukturierten Metallschicht (142, 144) in einer lateralen Richtung Y ist und der Gate-Source-Strompfad (GS) auf der ersten strukturierten Metallschicht (142) auch zumindest teilweise in der lateralen Richtung Y ist.

8. Transistorgehäuse nach Anspruch 5, wobei der Drain-Source-Strompfad (DS) nur auf der zweiten strukturierten Metallschicht (144) ist und der Gate-Source-Strompfad (GS) nur auf der ersten strukturierten Metallschicht (142) ist.

9. Transistorgehäuse nach Anspruch 8, wobei der Drain-Source-Strompfad (DS) auf der zweiten strukturierten Metallschicht (144) in einer lateralen Richtung Y ist und der Gate-Source-Strompfad (GS) auf der ersten strukturierten Metallschicht (142) auch zumindest teilweise in der lateralen Richtung Y ist.

10. Transistorgehäuse nach einem der Ansprüche 5 bis 9, wobei das separate Source-Sense-Gehäuseanschlusspad (144_1S) durch einen dedizierten Via (DV), durch den kein Drain-Source-Strom fließt, mit der ersten strukturierten Metallschicht (142) verbunden ist.

11. Transistorgehäuse nach einem der vorhergehenden Ansprüche, wobei die erste strukturierte Metallschicht (142) ein Mehrfinger-Drainsegment (142_2), das mit der Drainelektrodenmetallisierung (122_2) verbunden ist, und ein Mehrfinger-Sourcesegment (142_1) umfasst, das mit der Sourceelektrodenmetallisierung (122_1) verbunden ist, wobei das Mehrfinger-Drainsegment (142_2) und das Mehrfinger-Sourcesegment (142_1) ineinandergreifen.

12. Transistorgehäuse nach einem der vorhergehenden Ansprüche, wobei das Source-Gehäuseanschlusspad (144_1) entlang einer ersten Seite des Transistorgehäuses angeordnet ist, das Drain-Gehäuseanschlusspad (144_2) entlang einer zweiten Seite gegenüber der ersten Seite des Transistorgehäuses angeordnet ist und das Gate-Gehäuseanschlusspad (144_3) an einer Ecke der ersten Seite des Transistorgehäuses angeordnet ist.

13. Transistorgehäuse nach einem der Ansprüche 1 bis 11, wobei das Source-Gehäuseanschlusspad (144_1) entlang einer ersten Seite des Transistorgehäuses angeordnet ist, das Drain-Gehäuseanschlusspad (144_2) entlang einer zweiten Seite gegenüber der ersten Seite des Transistorgehäuses angeordnet ist und das Gate-Gehäuseanschlusspad (144_3) an einer dritten Seite des Transistorgehäuses in einem Gebiet angeordnet ist, das von einer Ecke der ersten oder der zweiten Seite des Transistorgehäuses beabstandet ist.

14. Transistorgehäuse nach einem der vorhergehenden Ansprüche, ferner umfassend:
eine Formmasse, die den Leistungstransistorchip (120) einbettet und das Mehrschichtlaminatsubstrat (140) außerhalb des Bereichs bedeckt, in dem der Leistungstransistorchip (120) platziert ist.

15. Transistorgehäuse nach einem der vorhergehenden Ansprüche, wobei der Leistungstransistorchip (120) ein HEMT-Transistorchip und/oder ein GaN-Transistorchip ist.

16. Transistorgehäuse nach einem der vorhergehenden Ansprüche, wobei der Leistungstransistorchip (120) dazu ausgelegt ist, Drain-Source-Spannungen zu schalten, die gleich oder größer als 50 V oder 100 V oder 150 V oder 200 V sind.

## Revendications

1. Boîtier de transistor pour puce de transistor de puissance, le boîtier de transistor comprenant :
la puce de transistor de puissance (120) ayant un premier côté (120A) et un second côté en regard du premier côté (120A), le premier côté (120A) comprenant une métallisation d'électrode de source (122_1), une métallisation d'électrode de drain (122_2) et une métallisation d'électrode de grille (122_3) ; et
un substrat stratifié multicouche (140) auquel est connectée la puce de transistor de puissance (120), le substrat stratifié multicouche (140) comprenant
une première couche métallique structurée (142) faisant face au premier côté (120A) de la puce de transistor de puissance (120) et étant électriquement connectée à la métallisation d'électrode de source (122_1), à la métallisation d'électrode de drain (122_2) et à la métallisation d'électrode de grille (122_3) ;
une seconde couche métallique structurée (144) comprenant une plage de connexion de boîtier de source (144_1), une plage de connexion de boîtier de détection de source (144_1S), une plage de connexion de boîtier de drain (144_2) et une plage de connexion de boîtier de grille (144_3) ;
au moins une couche isolante (550) est disposée entre la première couche métallique structurée (142) et la seconde couche métallique structurée (144) ; et
une pluralité de trous d'interconnexion (V) traversant la couche isolante (550) et connectant des segments de la première couche métallique structurée (142) aux plages de connexion de la seconde couche métallique structurée (144) ; **caractérisé en ce que**
la première couche métallique structurée (142), la seconde couche métallique structurée (144) et la pluralité de trous d'interconnexion (V) sont conçus de telle sorte qu'un chemin de courant grille-source (GS) entre la puce de transistor de puissance (120) et la plage de connexion de boîtier de détection de source (144_1S) soit fourni uniquement sur l'une des première et seconde couches métalliques structurées (142, 144) pendant qu'un chemin de courant drain-source (DS) entre la métallisation d'électrode de source (122_1) de la puce de transistor de puissance (120) et la plage de connexion de boîtier de source (144_1) se trouve au moins sur l'autre couche métallique structurée du substrat stratifié multicouche (140).

2. Boîtier de transistor selon la revendication 1, dans lequel la plage de connexion de boîtier de détection de source (144_1S) et la plage de connexion de boîtier de source (144_1) sont formées par un segment métallique continu de la seconde couche métallique structurée.

3. Boîtier de transistor selon la revendication 1 ou 2, dans lequel le chemin de courant drain-source (DS) est sur les première et seconde couches métalliques structurées (142, 144), et le chemin de courant grille-source (GS) est uniquement sur la seconde couche métallique structurée (144).

4. Boîtier de transistor selon la revendication 3, dans lequel le chemin de courant drain-source (DS) sur les première et seconde couches métalliques structurées (142, 144) est dans une direction latérale Y et le chemin de courant grille-source (GS) sur la seconde couche métallique structurée (144) est dans une direction latérale X, dans lequel la direction latérale Y et la direction latérale X sont différentes l'une de l'autre.

5. Boîtier de transistor selon la revendication 1, dans lequel la plage de connexion de boîtier de détection de source (144_1S) et la plage de connexion de boîtier de source (144_1) sont formées par des segments métalliques distincts de la seconde couche métallique structurée (144).

6. Boîtier de transistor selon la revendication 5, dans lequel le chemin de courant drain-source (DS) est sur les première et seconde couches métalliques structurées (142, 144), et le chemin de courant grille-source (GS) est uniquement sur la première couche métallique structurée (142).

7. Boîtier de transistor selon la revendication 6, dans lequel le chemin de courant drain-source (DS) sur les première et seconde couches métalliques structurées (142, 144) est dans une direction latérale Y et le chemin de courant grille-source (GS) sur la première couche métallique structurée (142) est également au moins partiellement dans la direction latérale Y.

8. Boîtier de transistor selon la revendication 5, dans lequel le chemin de courant drain-source (DS) est uniquement sur la seconde couche métallique structurée (144), et le chemin de courant grille-source (GS) est uniquement sur la première couche métallique structurée (142).

9. Boîtier de transistor selon la revendication 8, dans lequel le chemin de courant drain-source (DS) sur la seconde couche métallique structurée (144) est dans une direction latérale Y et le chemin de courant grille-source (GS) sur la première couche métallique structurée (142) est également au moins partiellement dans la direction latérale Y.

10. Boîtier de transistor selon l'une quelconque des revendications 5 à 9, dans lequel la plage de connexion de boîtier de détection de source (144_1S) distincte est connectée à la première couche métallique structurée (142) par un trou d'interconnexion dédié (DV) à travers lequel aucun courant drain-source ne circule.

11. Boîtier de transistor selon une quelconque revendication précédente, dans lequel la première couche métallique structurée (142) comprend un segment de drain à doigts multiples (142_2) connecté à la métallisation d'électrode de drain (122_2) et un segment de source à doigts multiples (142_1) connecté à la métallisation d'électrode de source (122_1), dans lequel le segment de drain à doigts multiples (142_2) et le segment de source à doigts multiples (142_1) sont interdigités.

12. Boîtier de transistor selon une quelconque revendication précédente, dans lequel la plage de connexion de boîtier de source (144_1) est agencée le long d'un premier côté du boîtier de transistor, la plage de connexion de boîtier de drain (144_2) est agencée le long d'un second côté en regard du premier côté du boîtier de transistor et la plage de connexion de boîtier de grille (144_3) est agencée à un coin du premier côté du boîtier de transistor.

13. Boîtier de transistor selon l'une quelconque des revendications 1 à 11, dans lequel la plage de connexion de boîtier de source (144_1) est agencée le long d'un premier côté du boîtier de transistor, la plage de connexion de boîtier de drain (144_2) est agencée le long d'un deuxième côté en regard du premier côté du boîtier de transistor et la plage de connexion de boîtier de grille (144_3) est agencée au niveau d'un troisième côté du boîtier de transistor dans une région espacée d'un coin du premier ou du deuxième côté du boîtier de transistor.

14. Boîtier de transistor selon une quelconque revendication précédente, comprenant en outre :
un composé de moule incorporant la puce de transistor de puissance (120) et recouvrant le substrat stratifié multicouche (140) à l'extérieur de la zone où est placée la puce de transistor de puissance (120).

15. Boîtier de transistor selon une quelconque revendication précédente, dans lequel la puce de transistor de puissance (120) est une puce de transistor HEMT et/ou une puce de transistor GaN.

16. Boîtier de transistor selon une quelconque revendication précédente, dans lequel la puce de transistor de puissance (120) est configurée pour commuter des tensions drain-source égales ou supérieures à 50 V ou 100 V ou 150 V ou 200 V.
